# EUROPEAN PATENT APPLICATION

(11) **EP 4 563 244 A1**
(43) Date of publication of application: **04.06.2025**
(21) Application number: 24214244.6
(22) Date of filing: 20.11.2024
(51) Int. Cl.: B05C 5/02

(54) **MACHINE FOR APPLYING CONDUCTIVE PASTE AND RELATED METHOD OF APPLYING A CONDUCTIVE PASTE**

(30) Priority: 29.11.2023 IT 202300025386
(71) Applicant: Keraglass S.r.l., 42031 Baiso (RE) (IT)
(72) Inventor: SPEZZANI, Stefano, 42031 BAISO (RE) (IT)
(74) Representative: Corradini, Corrado

(57) **Abstract**

A machine (10) for applying conductive paste comprising:
- a conveyor (20) provided with a horizontal support surface (A) configured to support a slab (L) and to move the slab along a horizontal advancement direction (B)
- a centring unit (30) configured to contact the slab by temporarily blocking and centring it on the support surface (A); and
- an application device (40) movable on the support surface at least along a first sliding direction (Y) parallel to the advancement direction (B), so that a conductive paste can be released in two or more given axial positions, defined along the first sliding direction (Y), of the slab on the support surface (A) following a translation along the first sliding direction (Y).

## Description

### TECHNICAL FIELD

The present invention concerns a machine for applying conductive paste, more in particular a machine for applying conductive paste configured to release one or more functional and/or decorative elements onto a slab, preferably a rigid slab, such as a glass slab or a ceramic slab or the like.

Even more preferably (but not in a limiting manner), the machine is in particular configured and is in particular suitable for applying one or more functional and/or decorative elements made with a conductive paste, for example a silver-based paste, for making conductive bars, strips, lines and/or tracks or the like on the slab (for example a low emissive glass slab).

### PRIOR ART

As is known, application machines are known which have a support surface on which a slab is intended to be supported, a (centring and) blocking unit, which laterally retains the slab during the application of the conductive paste and an applicator frame through which the conductive paste is applied to the upper surface of the slab.

It is known to use applicator frames that have a width and shape greater than or equal to the width and shape of the upper surface of the entire slab, which are arranged to apply the entire circuit of conductive paste intended to be transferred to the upper surface of the slab.

Therefore, for each format of slab to be processed, a respective applicator frame will be associated with a respective design.

A need felt in the sector is that deriving from the constant demand for greater versatility of these machines, which can therefore respond to the ever-increasing need to adapt quickly and efficiently to the changes of formats of the slabs to be processed and/or to the various needs of (aesthetic/functional) application of the same.

In particular, the need is felt to be able to repeat a functional/aesthetic element (for example the same functional/aesthetic element, such as a strip, a line, a bar, preferably conductive) in slabs of different format and/or in different positions and/or orientations of the same slab and/or in different positions in slabs that are equal or different from each other.

An object of the present invention is to satisfy these and other needs of the prior art, within the framework of a simple, rational and low cost solution.

These objects are achieved by the features of the invention set forth in the independent claim. The dependent claims outline preferred and/or in particular advantageous aspects of the invention.

### DISCLOSURE OF THE INVENTION

The invention, in particular, makes available a machine for applying conductive paste, preferably in the form of strips, lines, bars, inscriptions and/or designs, on slabs (preferably glass slabs) comprising:
- a conveyor provided with a horizontal support surface configured to support a slab and to move the slab along a horizontal advancement direction
- a centring unit configured to contact the slab by temporarily blocking and centring it on the support surface; and
- a device for applying a conductive paste movable on the support surface at least along a first sliding direction parallel to the advancement direction, so that a conductive element, preferably in the form of strips, lines, bars, bands, inscriptions and/or designs can be released/applied, in any given axial position, defined along the first sliding direction, of the slab resting on the support surface and/or one (same) conductive element can be released (repeating the same) in two or more axial positions of the same slab, defined along the first sliding direction, resting on the support surface following a translation along the first sliding direction.

Thanks to this solution, it is possible to achieve the aforementioned purposes and advantages.

In particular, it is possible to create more than one (identical) conductive element on the same slab, in respective predetermined positions, without requiring the creation of a customized applicator frame for each slab (which realizes the entire circuit) and of a size equal to the dimension of the slab.

According to an advantageous aspect of the invention, the application device can comprise a first applicator frame (configured to apply a conductive element made of a conductive paste on a surface of the slab) movable with respect to the conveyor along a first sliding direction parallel to the advancement direction, so as to be able to position the first applicator frame in any given axial position, defined along the advancement direction, of the slab resting on the support surface and to release a conductive element (made of conductive paste) thereon and/or to be able to release one (same) conductive element in two or more axial positions of the same slab.

For example, with such a first applicator frame it is possible to release one or more longitudinal conductive strips (with full or main width) on the slab, and repeat the conductive strip in various different positions of the slab (for example by making strips parallel to each other axially separated on the slab).

Advantageously, within this solution, the first applicator frame can have a longitudinal extension along a longitudinal axis substantially horizontal and orthogonal to the first sliding direction and have a length substantially equal to the width of the support surface along a direction orthogonal to the advancement direction and a width less than the length of the slab to be processed so that it can be arranged superimposed in plan in any axial portion thereof that is less than its total axial length, wherein preferably the first applicator frame has a minimum longitudinal stroke along the advancement direction at least twice the width of the first applicator frame (and substantially equal to the length of the conveyor).

Moreover, within the framework of this solution, the first applicator frame can be configured to release and apply a longitudinal conductive strip on the slab, wherein the conductive strip has a longitudinal (rectilinear) extension mainly orthogonal to the advancement direction and which extends longitudinally for a main portion of the length of the first applicator frame itself (and/or of the width of the slab to be processed).

Advantageously, the first applicator frame can be supported by a gantry frame of the machine, which is slidably associated with a frame of the conveyor along the first horizontal sliding direction parallel to the advancement direction.

Still, the first applicator frame can be vertically movable along a vertical direction, alternating between a position distal from the support surface and a position proximal to the support surface.

For example, the first applicator frame can comprise a (first) (suitably) perforated web (according to a given design/arrangement of holes), adapted to be crossed (in the holes thereof) by the conductive paste (for the creation of the conductive element, i.e. of the aforementioned conductive strip).

Still, the first applicator frame can be associated with at least a writing doctor blade and/or a spreading doctor blade movable vertically and along a second horizontal sliding direction parallel to a longitudinal axis of the first applicator frame.

Alternatively or in addition to what is described above (i.e. to the first applicator frame), the application device can comprise a second applicator frame (configured to apply a conductive element made of a conductive paste on a surface of the slab), wherein the second applicator frame is movable with respect to the conveyor along a first sliding direction parallel to the advancement direction, so as to be able to position the second applicator frame in any given axial position, defined along the advancement direction, of the slab resting on the support surface and release a conductive element (made of conductive paste) thereon and/or to be able to release one (same) conductive element (repeating the same) in two or more axial positions of the same slab, wherein for example the conductive element applied by the second applicator frame is different (in shape and/or function) from the conductive element applied by the first applicator frame.

Advantageously, the second applicator frame can also be movable with respect to the conveyor along a second horizontal sliding direction and orthogonal to the first sliding direction, so as to be able to position the second applicator frame in any given transverse position, defined along a horizontal direction and orthogonal to the advancement direction, of the slab resting on the support surface and to release one said conductive element thereon and/or to be able to release one (same) conductive element in two or more transverse positions of the same slab.

Thanks to this solution, the second applicator frame can be arranged in any axial and/or transverse position on the horizontal support surface, i.e. it is movable on a Cartesian plane so as to be arranged at any point on the slab and release a respective conductive element thereon.

Advantageously, the second applicator frame can be supported by a carriage slidably associated, along the second sliding direction, with a gantry frame slidably associated with a frame of the conveyor along the first horizontal sliding direction parallel to the advancement direction.

Still, the second applicator frame can be vertically movable along a vertical direction, alternating between a position distal from the support surface and a position proximal to the support surface.

Advantageously, the second applicator frame can be rotatable about a vertical rotation axis, preferably by an angle of rotation of 180°, so as to be able to vary the orientation on the slab of the conductive element applied by the second applicator frame.

Thanks to this, it is possible to orient differently the two or more conductive elements applied on the (same) slab by the second applicator frame.

Still, the second applicator frame can have a longitudinal extension along a substantially horizontal longitudinal axis and have a length less than the width of the support surface along a direction orthogonal to the advancement direction, wherein preferably the second applicator frame can have a minimum cross-sectional stroke along the second sliding direction at least equal to two times the length of the second applicator frame (and less than the width of the conveyor), and can have a width less than the length of the slab to be processed, wherein preferably the second applicator frame can have a minimum longitudinal stroke along the advancement direction of at least twice the width of the second applicator frame (and less than the length of the conveyor), so that it can be arranged superimposed in plan on any axial and transverse portion thereof included in its total length and width.

Advantageously, the second applicator frame can be configured to release and apply an inscription and/or design on the slab.

For example, the second applicator frame can comprise a (second) (suitably) perforated web (according to a given design/arrangement of holes), adapted to be crossed (in the holes thereof) by the conductive paste (for the creation of the conductive element, i.e. of the aforementioned inscription and/or design).

Still, the second applicator frame can be associated with at least one writing doctor blade and/or one spreading doctor blade movable vertically and along a horizontal sliding direction parallel to a longitudinal axis of the second applicator frame.

For the same purposes as stated above, a further aspect of the invention makes available a method of applying a conductive paste made by means of a machine according to any one of the preceding claims, comprising:
- arranging a slab resting on a horizontal support surface;
- centring and temporarily blocking the slab on the support surface and on the slab centred (and blocked) thereon;
- releasing and/or applying a conductive element (for example obtained from a conductive paste) to the slab, by means of an application device movable on the support surface, in a first given axial position of the slab;

- translating the application device on the support surface; and
- releasing and/or applying on the (same) slab an additional (identical) conductive element in a second, given axial position on the slab that is different from the first axial position by means of said application device.

Advantageously, the method may provide for rotating the application device about at least one vertical rotation axis before releasing/applying the further conductive element, so that the further conductive element has a different orientation with respect to the conductive element previously released/applied on the slab.

Furthermore, the method may comprise arranging a conductive paste for making each conductive element, wherein preferably the conductive paste is silver-based.

### BRIEF DESCRIPTION OF THE DRAWINGS

Further features and advantages of the invention will be more apparent after reading the following description provided by way of a non-limiting example, with the aid of the figures illustrated in the accompanying drawings.

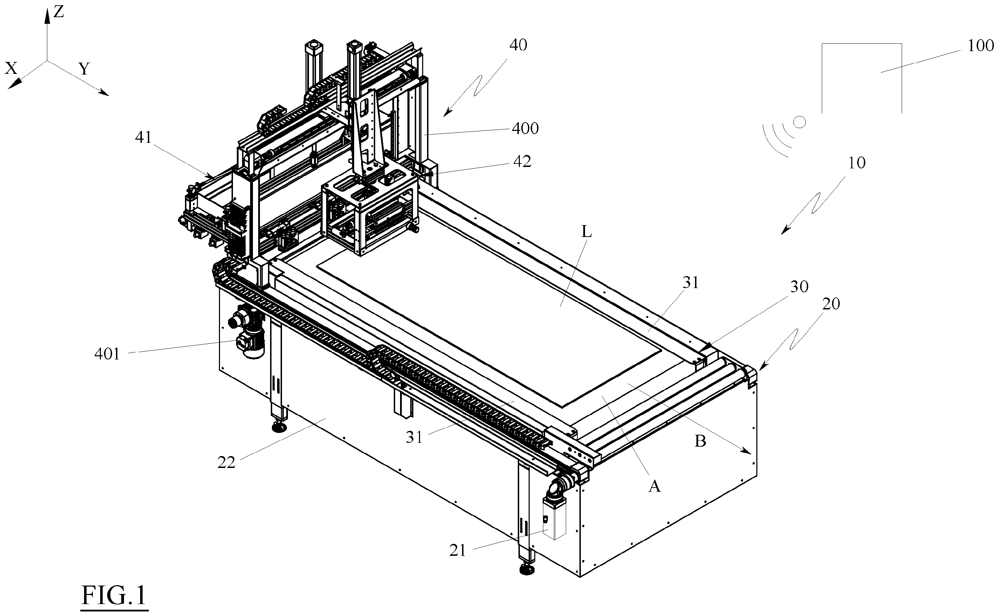

Figure 1 is a first axonometric view of a machine according to the invention.

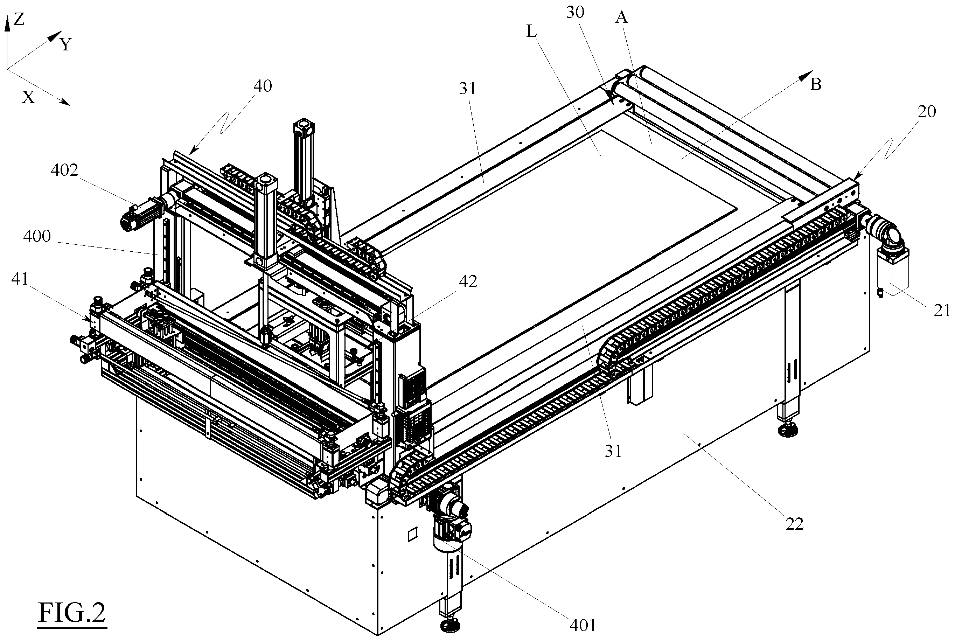

Figure 2 is a second axonometric view of the machine of Figure 1.

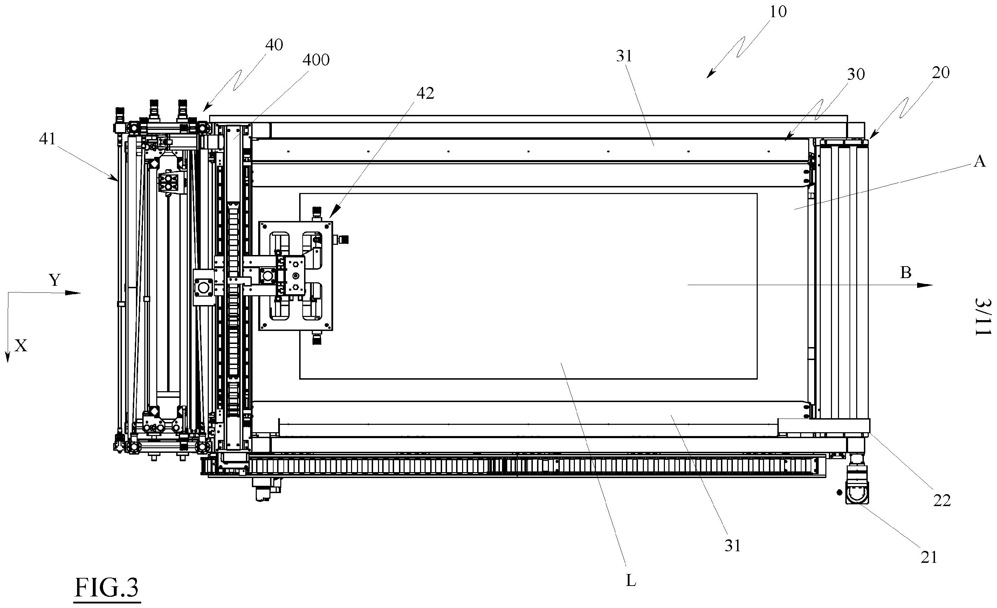

Figure 3 is a top plan view of Figure 1.

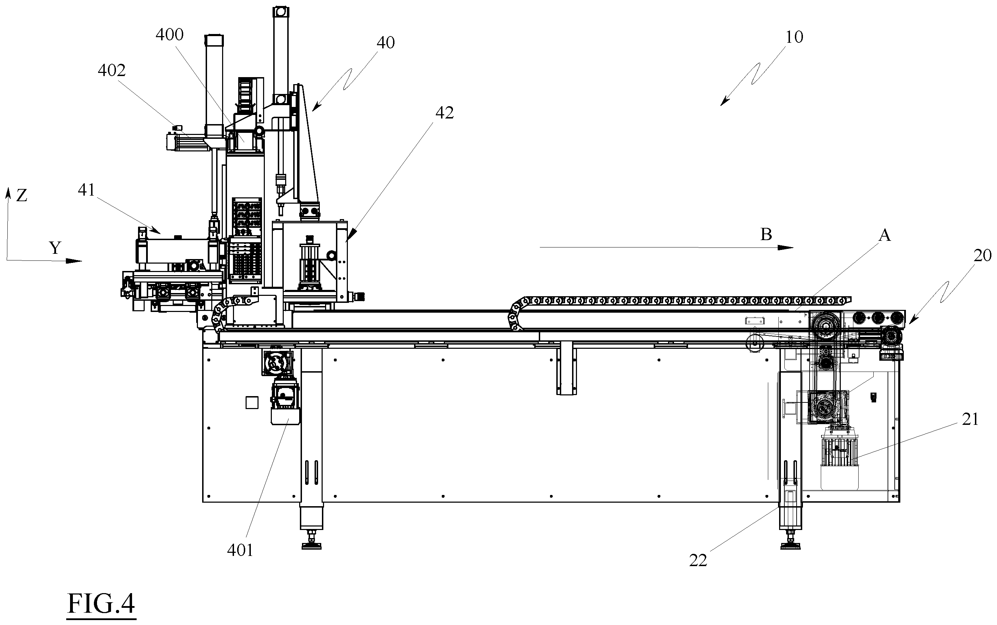

Figure 4 is a side elevational view (in partial section) of Figure 1.

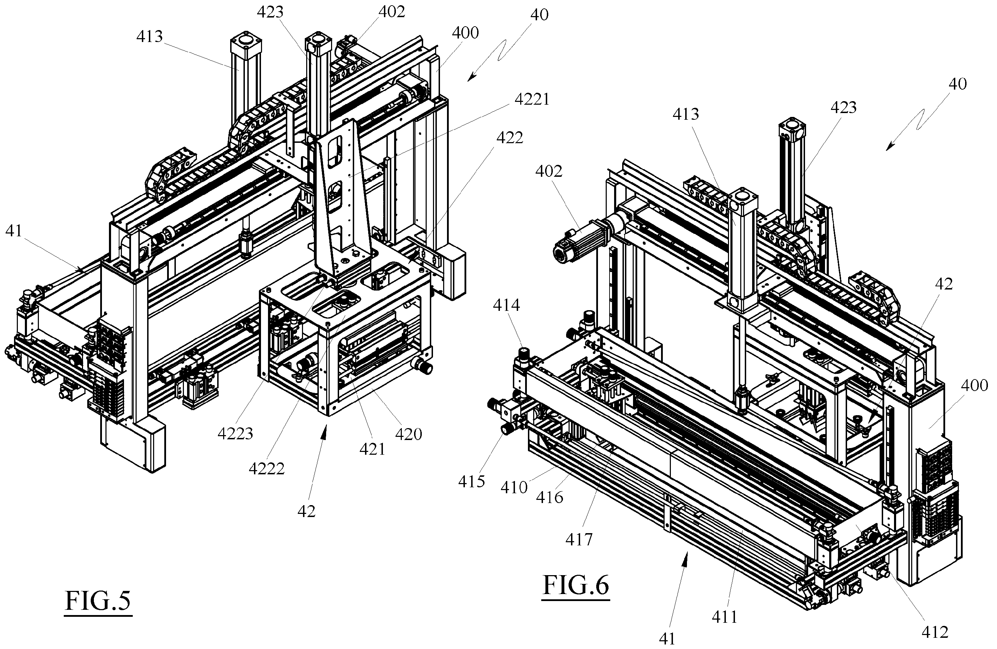

Figure 5 is a first axonometric view of a detail of an application device of the machine of Figure 1.
Figure 6 is a second axonometric view of Figure 5.

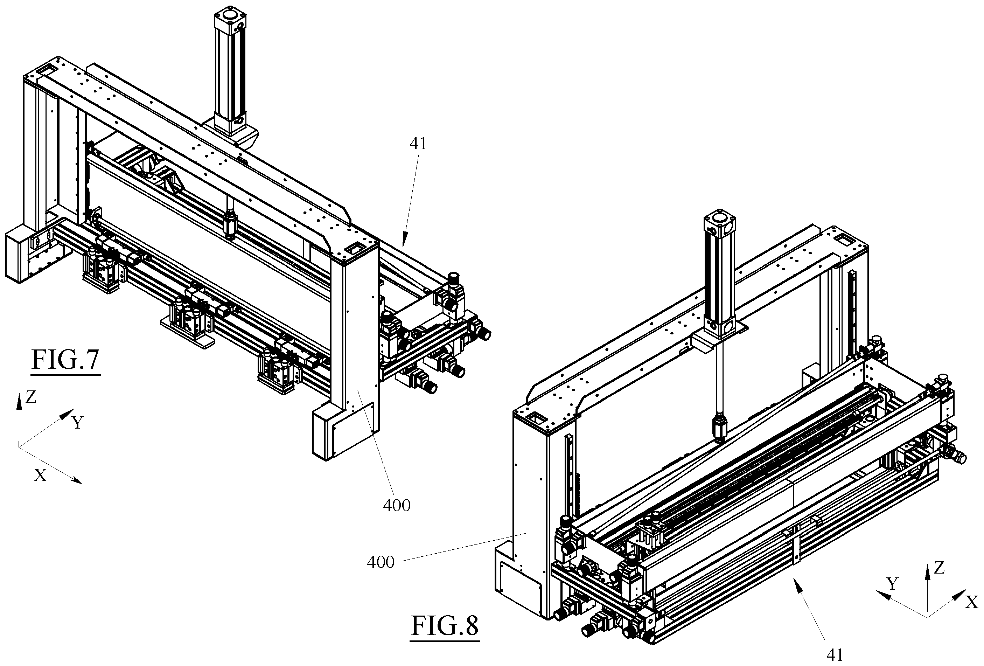

Figure 7 is a first axonometric view of a detail of a first application apparatus of the machine of Figure 1.
Figure 8 is a second axonometric view of Figure 7.

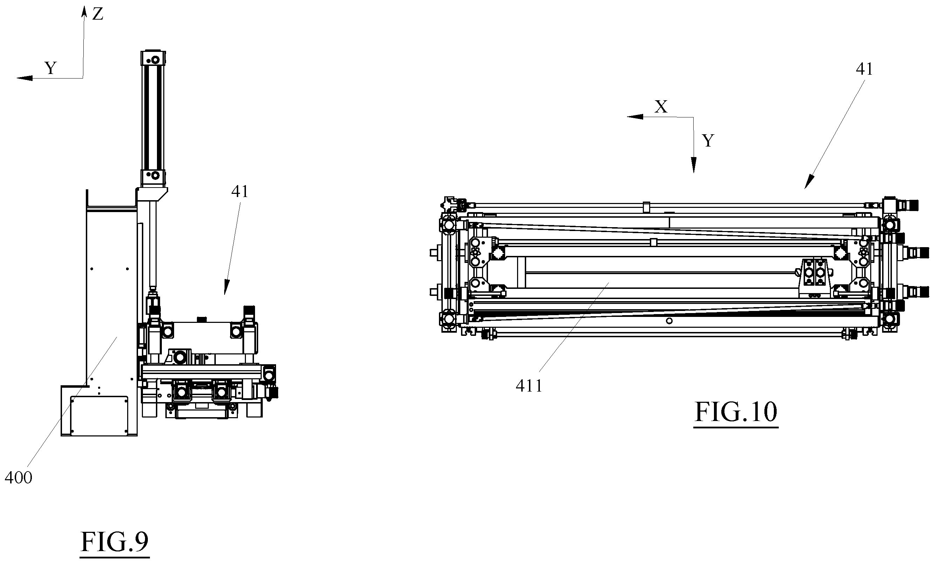

Figure 9 is a side elevational view of Figure 7.
Figure 10 is a top plan view of a first application apparatus of the machine of Figure 1.
Figure 11 is a first axonometric view of Figure 10.
Figure 12 is a second axonometric view of Figure 10.
Figure 13 is a first axonometric view of a detail of a second application apparatus of the machine of Figure 1.
Figure 14 is a second axonometric view of Figure 13.

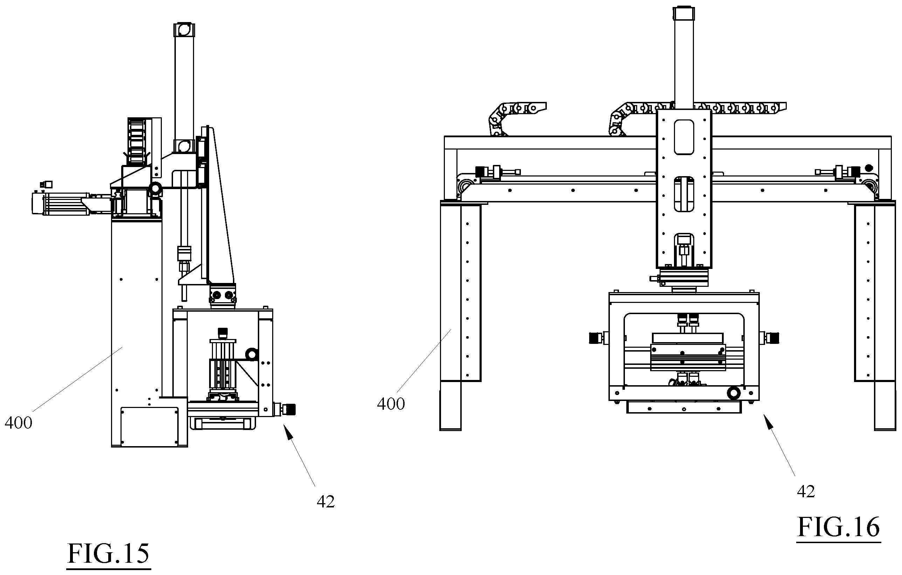

Figure 15 is a side elevational view of Figure 13.
Figure 16 is a front elevational view of Figure 13.

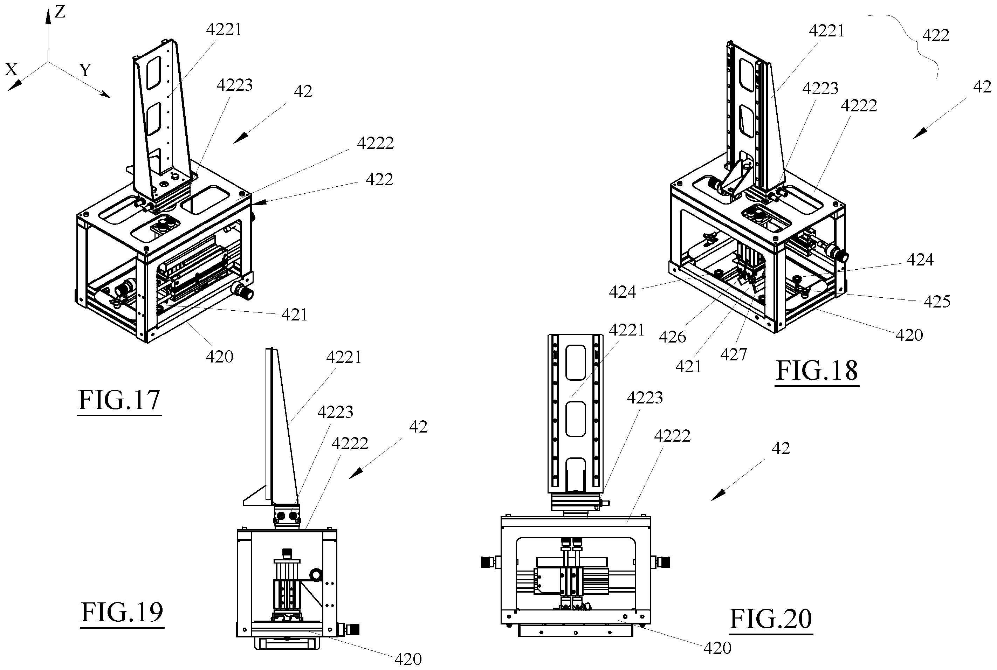

Figure 17 is an axonometric view of a second application apparatus of the machine of Figure 1.
Figure 18 is a second axonometric view of Figure 17.
Figure 19 is a side elevational view of Figure 17.
Figure 20 is a front elevational view of Figure 17.

### BEST MODE TO IMPLEMENT THE INVENTION

With particular reference to these figures, a machine for applying conductive paste has been indicated globally with 10.

The machine 10 is configured to release/apply one or more conductive elements (electrically) on a slab L.

By conductive element is meant here an aesthetic and/or functional element obtained by the application of a conductive paste, which is subjected to hardening/stabilization, for example by firing, becomes an electrical conductor.

In detail, a conductive element can be understood as a visible sign that can include, for example, a strip, a line, a bar, a band, or a set of lines (close together), an image, a design, an inscription or wording, an ornamental motif, a symbol, a pictogram, a logotype, etc., or any combination of the aforementioned elements.

Specifically, but not exclusively, the machine 10 in question can be used for processing slabs L, preferably flat slabs, such as, for example, glass slabs, ceramic slabs or other rigid slabs.

Specifically, but not exclusively, the conductive element is obtained by applying on (a surface of) a slab an appropriate conductive paste, preferably silver-based, to be subjected to appropriate firing and/or thermal cycle once applied.

Preferably, the machine 10 is in particular suitable or configured primarily for the application of conductive elements (functional and/or aesthetic) obtained by means of conductive paste, for example on a glass slab, such as for example a silver conductive paste (which subjected to a specific firing process - with the glass slab - becomes a real conductive bar applied stably to the surface of the slab for various applications, such as for example the heating of the glass slab, for example in refrigerators or in rear windows of cars or other application).

It is not excluded that alternatively or in addition to the above, the machine 10 may be in particular suitable or mainly configured for the application of conductive elements (functional and/or aesthetic) obtained by means of different types of pastes (to be subjected to firing or simply to be subjected to hardening/drying or other fixing process).

The machine 10 comprises a support for supporting at least one slab L resting on its lower support surface opposite the upper surface to be processed.

The support comprises a horizontal support surface on which the slabs L are intended to rest with their (upper) surface to be processed/finished facing upwards.

The support preferably comprises an advancement unit for (taking over and) advancing the slab L supported on the support surface A along a predetermined horizontal (substantially rectilinear) advancement direction B.

In the illustrated preferred example, the advancement unit comprises a conveyor 20. The conveyor 20 is preferably but not in a limiting manner a belt conveyor.

In detail, the advancement unit and/or the support surface A is defined by the (upper branch of the) conveyor belt of the belt conveyor.

Preferably, but not in a limiting manner, the conveyor belt is ring-wound on a pair of end rollers, of which a driving roller and a driven roller, wherein the driving roller is connected to a motor 21, preferably provided with an encoder.

The speed of rotation of the rollers regulates the advancement speed of the slabs L along the advancement direction B, which is settable and adjustable according to the processing needs.

The conveyor 20 can also be configured to stop the slab L resting on the support surface A in a certain processing position (for example by stopping the motor 21 of the belt conveyor).

Below the (upper branch of the) conveyor belt there may be provided a planar plate (as wide as the support surface A defined by the conveyor 20) on which the (upper branch of the) conveyor belt slides, to maintain the same planar.

For example, the support surface A is extended axially by an inlet (short) roller conveyor and/or an outlet (short) roller conveyor.

The conveyor 20 is provided with a ground support frame 22 which supports the belt conveyor and the slab L resting and/or transiting thereon.

The conveyor 20 and/or the support surface A may have a main dimension or length parallel to the advancement direction B imposed by the belt conveyor.

In other words, the conveyor 20 and/or the support surface A defined by it extends longitudinally along a horizontal longitudinal axis thereof parallel to the advancement direction B (imposed by the belt conveyor).

The advancement unit could alternatively be defined by a roller conveyor or other conveyor of a type known in the art.

The machine 10 comprises a centring unit 30 configured to centre the slab L on the support surface A.

In detail, the centring unit 30 is configured to contact the slab L by temporarily blocking it, that is, by retaining or stopping its motion imposed by the advancement unit, and centring it on the support surface A defined by the conveyor 20, for example in a predefined (lateral) position of zero on the support surface A.

The centring unit 30 is configured to stop the motion and temporarily block the advancement of the slab L on the support surface A (along the advancement direction B), regardless of the stop of the conveyor 20.

In practice, the centring unit 30 is configured to stop and temporarily block the slab L on the support surface A, preventing the slab L from being able to move even accidentally and imperceptibly on the support surface A, for as long as necessary for the processing operations.

In other words, the centring unit 30 is configured to define a (temporary) constraint for the slab L resting on the support surface A, additional with respect to the constraint defined by the support surface itself.

The centring unit 30 is preferably, but not in a limiting manner, movable on the conveyor 20, i.e. at least partially above it.

The centring unit 30 comprises, in the example illustrated, a pair of (longitudinal) bars 31 reciprocally movable on the conveyor 20 and configured to laterally clamp in a releasable manner the slab L resting on the support surface A of the conveyor 20.

In practice, the bars 31 are movable, above the support surface A (touching the same), reciprocally along a movement direction orthogonal to the advancement direction B, which is imposed on the slab L by the conveyor 20.

In a possible embodiment, both bars 31 are movable with respect to the support surface A, towards and/or away from each other; however, it is not excluded, as in the preferred case illustrated in the figures) that one of the two bars 31 can be fixed (or adjustable and then kept fixed in a certain adjustable reference position) on the support surface A and the other bar 31 is movable with respect to said fixed bar 31 (to clamp the slab L between them).

Each bar 31 is defined by an elongated (and thin), plate-like body, which has a horizontal longitudinal axis parallel to the advancement direction B of the slabs L.

Each bar 31 comprises an internal vertical wall, i.e. facing the other bar 31, adapted to define a (planar and vertical) surface of contact with the slab L, i.e. with the opposite side walls of the slab L parallel to the advancement direction B.

The internal vertical wall can be, for example, covered with a gasket or (elastic) damping element, such as a rubber coating or in any case resilient, to soften the area of mutual contact between the bar 31 and the slab L.

The bars 31 are mutually movable between a spread apart position, in which the mutual distance (i.e. the distance between the two internal vertical walls) is maximum and is greater than the width of the slab L (i.e. its dimension orthogonal to the advancement direction B thereof that can be processed with the machine 10), and a contracted position, in which the mutual distance (i.e. the distance between the two internal vertical walls) is minimum and is equal to the (said) width of the slab L, i.e. in the contracted position both bars 31 are in contact with (the lateral flanks of) the slab L resting on the support surface A.

In practice, when the bars 31 are in their spread apart position they allow the advancement of the slab L on the support surface A along the advancement direction B, as they do not interfere therewith, when instead the bars 31 move into their contracted position (and a slab L is interposed between them) they stop by interference the advancement of the slab L along the advancement direction B, preventing any relative movement between the slab L and the support surface A.

The distance of the bars 31 from the support surface A of the slabs L is not less than the thickness of the slabs L that can be processed with the machine 10.

For example, the distance of the bars 31 from the support surface A is adjustable as a function of the thickness of the slab L resting on the support surface A.

For example, the distance of the bars 31 from the support surface A is such that the bar 31 comes into contact with a central area of the thickness of the slab L.

Each bar 31 may consist of a plurality of contiguous aligned and/or mutually spaced sections or of a monolithic bar (as illustrated).

The centring unit 30 then comprises an actuation unit configured to actuate the bars 31 in reciprocal motion, as described above, alternately between the spread apart position and the contracted position.

The actuation unit comprises, for example, one or more linear actuators, (for example one for each bar 31 or one only for the single movable bar 31) for example a pneumatic actuator, with horizontal axis.

For the fine adjustment of the movement between the spread apart position and the contracted position or the centring thereof as a function of the width of the slab L (in the direction orthogonal to the advancement direction B thereof), it is possible to provide that the actuation unit may comprise a motor, for example a rotary motor, adapted to horizontally move a respective bar 31 or, as in the preferred embodiment, one of the bars (or both) the bars 31.

In addition, the machine 10 comprises a system for detecting a slab L resting on a section of the support surface A.

For example, the detection system is configured to detect the front end (in the advancement sense along the advancement direction B) of the slab L at a predetermined axial position of the support surface A along the advancement direction B.

For example, the detection system comprises an optical unit, which has for example a (not illustrated) photocell (and a respective reference body aligned to the photocell along a horizontal direction and orthogonal to the advancement direction).

The front end (or front face) of the slab L when - during the advancement along the advancement direction B - meets the beam of light emitted by the photocell interrupts it and the detection system is configured to generate an (electrical) signal indicative of a predetermined axial position of the slab L on the support surface A.

For example, the optical unit is associated with the frame 22 of the conveyor 20 (above the support surface A).

In practice, by detecting the front face of the slab L and knowing the advancement speed of the conveyor 20 (with the motor 21 provided with encoder), it is possible to define the axial reference position of the slab L on the support surface A in which to stop the slab L. Through the centring unit 30, then, it is possible to define the transverse reference position of the slab L on the support surface A in which to stop the slab L.

The machine 10 comprises an application device 40, which is configured to apply and/or release (in an automated or semi-automated manner) one or more conductive elements (i.e. aesthetic and/or functional conductive elements) on the (upper surface of) slab L.

The application device 40 is preferably movable on the support surface A, so as to be able to be positioned in any predeterminable position thereof and release thereon at least one conductive element (i.e. an element formed by a conductive paste having a predetermined shape and dimension, preferably thin), as will be better described below.

For example, the overall conductive circuit applied on the slab L at the end of processing will be defined by a plurality of (e.g. equal) non-overlapping (and e.g. parallel) mutually conductive elements released and/or applied on the slab L at predetermined (different) positions on the (upper surface of) the slab L obtained following one or more displacements (and relative positionings) of the application device 40.

The application device 40 is suspended on the support surface A of the conveyor 20, for example at a non-zero distance therefrom, and is at least movable parallel to the support surface A with respect to the conveyor 20 itself.

Preferably, the application device 40 is movable, i.e. translatable, on the support surface at least along a first sliding direction Y parallel to the advancement direction B.

In particular, the machine 10 and/or the application device 40 comprises a frame 400, which rises above with respect to the support surface A.

The frame 400 comprises two (vertical) uprights, for example flanked to the support surface A (along a horizontal flanking direction and, for example, orthogonal to the advancement direction B imposed by the conveyor 20 to the slabs L) and on opposite sides with respect to it, which rise vertically above with respect to the support surface A.

Preferably, the frame 400 further comprises an upper (horizontal) crosspiece that joins (at a predetermined height higher than the support surface A) the two uprights.

In practice, the frame 400 is substantially configured as a gantry and is crossed (along the advancement direction B) by the support surface A.

The frame 400 is slidably connected to the conveyor 20, for example to the frame 22 thereof, for example by means of the uprights.

In particular, the frame 22 comprises longitudinal sliding guides to which suitable sliding shoes fixed to the uprights of the frame 400 are slidably associated allowing the axial sliding of the frame 400 with respect to the (frame 22 of the) conveyor 20.

Advantageously, the frame 400 is movable on the conveyor 20 being able to travel a stroke along the first sliding direction Y substantially equal to (or greater than) the length of the support surface A (along the advancement direction B).

The frame 400 is driven to slide along the first sliding direction Y, preferably in the two sliding directions, by a linear actuator unit.

Preferably, but not in a limiting manner, the actuator unit comprises (or consists of) a main motor 401, preferably provided with an encoder, which is for example supported by the frame 22 of the conveyor 20 or by one of the uprights of the frame 400.

Preferably, the application device 40 comprises a first application apparatus 41, which is configured to release/apply a first conductive element (e.g. a first type of conductive element).

The first application apparatus 41 comprises a first support frame 410 configured to support (replaceably) a first applicator frame 411 (configured to release/apply on the slab L the aforementioned first conductive element).

The first support frame 410 is for example shaped as a (horizontal) framing, substantially quadrangular, preferably rectangular, inside which the first applicator frame 411 is supported (so that it lies on a substantially horizontal plane).

The first support frame 410 and/or the first applicator frame 411 has (a rectangular shape and) a longitudinal extension along a longitudinal axis substantially horizontal and orthogonal to the first sliding direction Y.

Advantageously, the first support frame 410 and/or the first applicator frame 411 has a length substantially equal to the width of the support surface A along a direction orthogonal to the advancement direction B and a width (much) less than the length of the support surface A, i.e. (much) less than the length of the slab L to be processed.

In detail, the width of the first support frame 410 and/or of the first applicator frame 411 (i.e. its dimension along the advancement direction B) is less than half the length of the support surface A (preferably less than ¼ of such length).

The first applicator frame 411 is preferably configured to release and apply on the (upper surface of each) slab L a first longitudinal conductive element having a main dimension mainly orthogonal to the advancement direction B and extending longitudinally for a main portion of the length of the first applicator frame 411 itself (and/or of the width of the slab L to be processed).

Advantageously, the first applicator frame 411 is preferably configured to release and apply on the (upper surface of each) slab L a longitudinal (thin) strip, wherein the longitudinal strip has a longitudinal extension (preferably, but not in a limiting manner, rectilinear) mainly orthogonal to the advancement direction and extending longitudinally for a main portion of the length of the first applicator frame 411 itself (and/or of the width of the slab L to be processed).

The first support frame 410 (and therewith the first applicator frame 411) is supported (and carried) by the frame 400 and, therefore, is movable therewith on the support surface A of the conveyor 20 along the first sliding direction Y.

In this way it is possible to position the first applicator frame 411 in any given axial position of the slab L (resting on the support surface A), defined along the advancement direction B and/or the first sliding direction Y.

In greater detail, in this way (and thanks to the dimension of the first applicator frame 411) it is possible to position the first applicator frame 411 in any two or more certain distinct axial positions of the slab L (resting on the support surface A), defined along the advancement direction B and/or the first sliding direction Y, and to release a respective first conductive element thereon, i.e. to be able to release one (same) first conductive element in (respective) two or more given axial positions of the same slab L.

In practice, the first support frame 410 and/or the first applicator frame 411 can be arranged, thanks to the translation of the frame 400 along the first sliding direction Y, superimposed in plan on any axial portion of the slab L smaller than its total axial length (for example an entire sub-multiple thereof), or on any two distinct axial positions of the slab L.

The frame 400 and/or the first support frame 410 (and therewith the first applicator frame 411) has a longitudinal stroke, along the first sliding direction Y, at least twice the width of the first support frame and/or of the first applicator frame (and substantially equal to or slightly less than the length of the support surface A and/or of the conveyor 20).

Preferably, the first support frame 410 and/or the first applicator frame 411 is vertically movable along a vertical direction Z (orthogonal to the support surface A) towards and/or away from the support surface A, i.e. alternatively between at least one position distal from the support surface A and at least one position proximal to the support surface A.

In practice, the first support frame 410 and/or the first applicator frame 411 is supported by the frame 400 with the possibility of sliding vertically along the vertical direction Z.

Preferably, the first support frame 410 and/or the first applicator frame 411 are allowed two independent vertical translations along the vertical direction Z, of which a main translation and a fine adjustment translation (having a translation stroke smaller than the main translation).

For example, the first support frame 410 is supported by a first support carriage 412, preferably but not in a limiting manner also shaped as a framing, which is constrained to the frame 400 by means of a constraint, preferably a prismatic connection, which allows (exclusively) a sliding of the first carriage 412 with respect to the frame 400 with respect to the vertical direction Z.

In practice, the frame 400 comprises a vertical guide (for example one at each of its uprights) engaged by a sliding shoe fixed to the first carriage 412.

For example, the first carriage 412 is superimposed in plan to the first support frame 410. Still, the first carriage 412 is constrained to the frame 400 at a facade thereof, preferably its rear facade or its front facade (orthogonal to the first sliding direction Y and/or to the advancement direction B).

The stroke allowed to the first carriage 412 by the connection with the frame 400 defines the main translation mentioned above.

The first carriage 412 is driven to slide along the vertical direction Z, preferably in the two sliding directions, by a linear actuator unit.

Preferably, but not in a limiting manner, the actuator unit comprises (or consists of) a first pneumatic jack 413, which is for example supported by the frame 400, for example at the (centre line of) the crosspiece.

Preferably, the actuator unit can be configured to stop the first carriage 412 in at least a first distal position, in which the first carriage 412 is at the maximum distance from the support surface A (for example in which the translation of the frame 400 along the first sliding direction Y is allowed), and in at least a first proximal position, in which the first carriage 412 is at the minimum distance from the support surface A (for example with the first applicator frame 411 at a given non-zero distance therefrom).

Furthermore, it is possible to provide that the actuator unit can be configured to stop the first carriage 412 in at least an intermediate position between the first distal position and the first proximal position, for example to allow/facilitate the operations of changing the first applicator frame 411 and/or of maintenance/cleaning thereof.

Furthermore, the first support frame 410 is constrained to the first carriage 412 by means of a constraint, preferably a prismatic connection, which allows at least one sliding of the first support frame 410 on the first carriage 412 with respect to the vertical direction Z.

In practice, the first carriage 412 comprises a vertical guide engaged by a sliding shoe fixed to the first support frame 410.

The first support frame 410 is movable with respect to the first carriage 412, sliding, between a raised position and a lowered position.

The stroke allowed to the first support frame 410 by the connection with the first carriage 412 defines the said fine adjustment translation.

The first support frame 410 is driven to slide, with respect to the first carriage 412, along the vertical direction Z, preferably in the two sliding directions, by a linear actuation unit.

Preferably, but not in a limiting manner, the linear actuation unit can be of the manual or automatic type.

In the illustrated example, the linear actuation unit is of a manual type and comprises (or consists of) a first knob 414 (or handwheel), which is for example supported by the first carriage 412 and is connected to at least one (manual) screw actuator.

Preferably, the first knob 414 is connected to a plurality of screw actuators, for example 4 in number (one for each edge of the first carriage 412), for example synchronized (two by two) by means of respective cardan transmissions.

It is not excluded that the linear actuation unit is provided with one or more motors adapted to adjust the height of the first support frame 410 with respect to the first carriage 412.

This fine adjustment translation allows to adjust the contact pressure and/or the contact position between the first applicator frame 411 and the (upper surface of the) slab L (as a function of its thickness and/or other processing parameters).

It is also not excluded that the overall translation (i.e. the sum of the aforementioned main translation and the aforementioned fine adjustment translation) of the first support frame 410 can be carried out by a single actuator (motorized or manual), for example an electric motor or the like.

Still, the first applicator frame 411 may be associated in an oscillating/rotational manner about a vertical oscillation axis.

Preferably, the first applicator frame 411 can be constrained to the first support frame 410 by means of a further constraint that allows (small) oscillations of the first applicator frame 411 with respect to the first support frame 410 around the vertical oscillation axis (central, i.e. placed at the intersection of the diagonals of the first support frame 410).

In this way it is possible to adjust (in a fine way) the orientation on the horizontal plane of the first applicator frame 411 (i.e. of the first conductive element made by it on the slab L).

The first applicator frame 411 is driven to oscillate, with respect to the first support frame 410, around said axis of vertical oscillation preferably in the two directions, by an adjustment unit.

Preferably, but not in a limiting manner, the adjustment unit can be of the manual (or automatic) type.

In the illustrated example, the adjustment unit is of the manual type and comprises (or consists of) a first knob 415, which is for example supported by the first support frame 410 and is connected to at least one (manual) screw actuator.

Preferably, said first knob 415 is connected to a plurality of screw actuators, for example 4 in number (one for each edge of the first support frame 410), for example synchronized (two by two) by respective cardan transmissions.

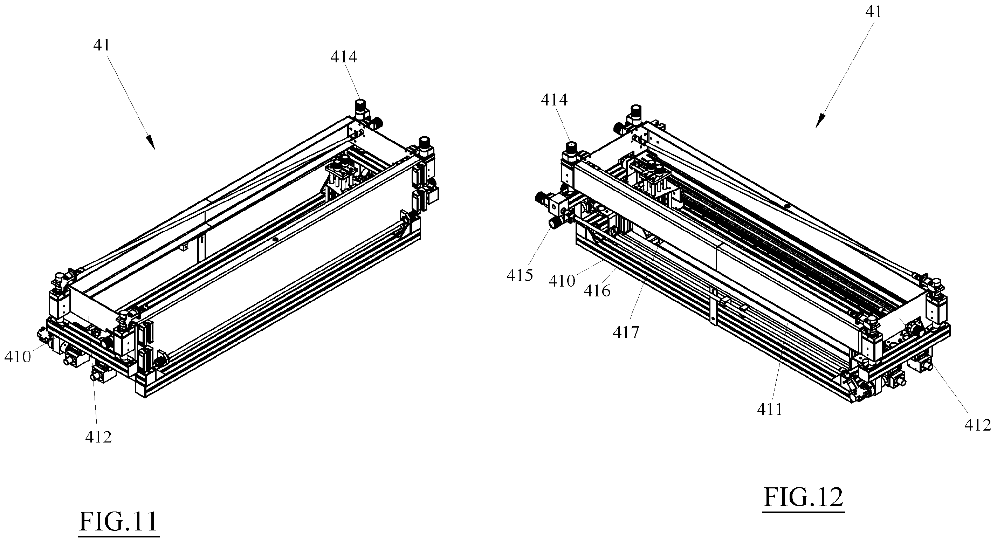

The first applicator frame 411, as illustrated in the figures - in particular shown in Figure 11 -, comprises a (first) (suitably) perforated web (according to a given design/arrangement of holes), adapted to be crossed (in the holes thereof) by the conductive paste (for the creation of the first conductive element, i.e. of the aforementioned conductive strip).

The perforated web is supported within the first support frame 410, as mentioned shaped as a (horizontal) framing, for example so that the perforated web lies on a substantially horizontal surface.

The first application apparatus 41 further comprises at least one movable doctor blade on the first applicator frame 411 for spreading the conductive paste thereon and/or for releasing the first conductive element (on the slab) therefrom, for example by passing through the holes of the (first) perforated web by means of the pressure exerted by the doctor blade.

For example, the first application apparatus 41 comprises a first spreading doctor blade 416 which is supported above the first applicator frame 411 for example by the first support frame 410 or by the first carriage 412.

The first spreading doctor blade 416 is for example made of metal.

Preferably, the first spreading doctor blade 416 is vertically movable between a raised position, in which it is distal from the first applicator frame 411, and a lowered position, in which it is proximal to the first applicator frame 411, for example at a non-zero distance therefrom or in close proximity thereto.

Preferably, the first spreading doctor blade 416 is driven in vertical translation by an actuator, preferably a pneumatic jack.

In detail, the first spreading doctor blade 416 is fixed to the free (lower) end of the stem of the pneumatic jack.

The first spreading doctor blade 416, moreover, is movable in translation along a second horizontal sliding direction X, for example parallel to the longitudinal axis of the first support frame 410 and/or of the first applicator frame 411 (i.e. orthogonal to the first sliding direction Y), for example between two corresponding end positions, preferably adjustable and/or defined by the axial ends of the first applicator frame 411 (and/or of the first longitudinal conductive element defined thereby).

Preferably, the body of the pneumatic jack is guided on longitudinal guides (fixed to the first support frame 410 and/or to the first carriage 412) so as to be able to slide along said horizontal sliding direction.

A motorized and/or pneumatically operated actuation unit (not illustrated), for example fixed to the first support frame 410 and/or to the first carriage 412, is configured to drive the translation of the first spreading doctor blade 416 alternately between the two end positions.

For example, the first spreading doctor blade 416 is configured to operate a forward (or spreading) stroke, from an end rest position to an opposite end position, when in the lowered position and a return stroke toward the end rest position when in the raised position.

A conductive paste dispensing unit (not illustrated) is configured to dispense a predetermined amount of conductive paste onto the first applicator frame 411 when the first spreading doctor blade 416 is in the end rest position prior to the forward stroke (so that it can be spread along the entire first applicator frame 411 in the forward stroke thereof). For example, the first application apparatus 41 comprises a first writing doctor blade 417 which is supported above the first applicator frame 411 for example by the first support frame 410 or by the first carriage 412.

The first writing doctor blade 417 is for example made of rubber and/or a plastic material. Preferably, the first writing doctor blade 417 is vertically movable between a raised position, in which it is distal from the first applicator frame 411, and a lowered position, in which it is proximal to the first applicator frame 411, for example in forced contact therewith (such as to tension it downwards and bring it into contact with the underlying slab L). Preferably, the first writing doctor blade 417 is driven in vertical translation by an (independent) actuator, preferably a pneumatic jack.

In detail, the first writing doctor blade 417 is fixed to the free (lower) end of the stem of the pneumatic jack.

The first writing doctor blade 417, moreover, is movable in translation along the second horizontal sliding direction X, for example between two corresponding end positions, preferably adjustable and/or defined by the axial ends of the first applicator frame 411 (and/or of the first longitudinal conductive element defined thereby).

Preferably, the body of the pneumatic jack is guided on (the same aforementioned) longitudinal guides (fixed to the first support frame 410 and/or to the first carriage 412) so as to be able to slide along said horizontal sliding direction.

An actuation unit (preferably the same that simultaneously drives the spreading doctor blade) that is motorized and/or pneumatically operated (not illustrated), for example fixed to the first support frame 410 and/or to the first carriage 412, is configured to drive the translation of the first writing doctor blade 417 alternately between the two end positions. For example, the first writing doctor blade 417 is configured to operate a forward (or write) stroke, from an end rest position to an opposite end position, when in the lowered position and a return stroke toward the end rest position when in the raised position.

The forward stroke of the first writing doctor blade 417 follows the forward stroke (and the subsequent return stroke) of the first spreading doctor blade 416, so as to pass the conductive paste (previously spread by the first spreading doctor blade 416) through (determined and calibrated open pores of) the first applicator frame 411 during the forward stroke of the first writing doctor blade 417 (with the first writing doctor blade itself kept pressed in its lowered position on the first applicator frame itself), thereby releasing and applying a predetermined amount of conductive paste defining the first conductive element (in the predetermined axial position) on the slab L arranged under the first applicator frame 411.

The first application apparatus 41, moreover, could provide an "out of contact" device (not illustrated, as of a type known in the field), which is a servo-actuated device configured to lift the rear front of the first applicator frame 411 in the advancement direction of the first writing doctor blade 417 in its forward stroke, during the forward stroke thereof, so as to detach the portion of the first applicator frame 411 on which the first writing doctor blade 417 has already passed from the slab L (to improve the definition/precision of the conductive element obtained).

Furthermore, preferably, the application device 40 comprises a second application apparatus 42, which is configured to release/apply a first conductive element (for example a second type of conductive element), wherein preferably the second conductive element (applied/released by the second application apparatus 42) is different from the first conductive element (applied/released by the first application apparatus 41), for example both in type and in shape and/or function.

The second application apparatus 42 comprises a second support frame 420 configured to support (replaceably) a second applicator frame 421 (different from the first applicator frame both in shape and in the conductive element released therefrom).

The second support frame 420 is for example shaped as a (horizontal) framing, substantially quadrangular, preferably rectangular, inside which the second applicator frame 421 is supported (so that it lies on a substantially horizontal plane).

The second support frame 420 and/or the second applicator frame 421 has (a rectangular shape and) a longitudinal extension along a substantially horizontal longitudinal axis thereof.

For example, the length of the second support frame 420 and/or the second applicator frame 421 along its longitudinal axis is less than (substantially half) the length of the first support frame 410 and/or of the first applicator frame 411 (respectively).

Advantageously, the second support frame 420 and/or the second applicator frame 421 has a length substantially less than (substantially equal or comparable to half) the width of the support surface A along a direction orthogonal to the advancement direction B and a width (much) less than the length of the support surface A, i.e. (much) less than the length of the slab L to be processed.

In detail, the width of the second support frame 420 and/or of the second applicator frame 421 (i.e. its horizontal dimension orthogonal to its longitudinal axis) is less than half the length of the support surface A (preferably less than ¼ of that length).

The second applicator frame 421 is preferably configured to release and apply on the (upper surface of each) slab L a second conductive element, for example having a predefined (unique) orientation.

For example, the second conductive element is of the type of an inscription (or any wording) and/or a design (e.g. a logotype or other type of design/ornament).

Advantageously, the second applicator frame 421 is preferably configured to release and apply on the (upper surface of each) slab L an inscription and/or a design, wherein the inscription and/or the design could extend mainly along a direction orthogonal to the advancement direction B and extending longitudinally for a minority portion of the width of the slab L to be processed.

The second support frame 420 is supported (and carried) by the frame 400 and, therefore, is movable therewith on the support surface A of the conveyor 20 along the first sliding direction Y.

In this way it is possible to position the second applicator frame 421 in any given axial position of the slab L (resting on the support surface L), defined along the advancement direction B and/or the first sliding direction Y.

In greater detail, in this way (and thanks to the dimension/width of the second applicator frame 421) it is possible to position the second applicator frame 421 in any two or more given distinct axial positions of the slab L (resting on the support surface L), defined along the advancement direction B and/or the first sliding direction Y, and release a respective second conductive element thereon, i.e. to be able to release one (same) second conductive element in two or more given axial positions of the same slab L.

In practice, the second support frame 420 and/or the second applicator frame 421 can be arranged, thanks to the translation of the frame 400 along the first sliding direction Y, superimposed in plan on any axial portion of the slab smaller than its total axial length (for example an entire sub-multiple thereof), or on any two distinct axial positions of the slab L.

The frame 400 and/or the second support frame 420 (and therewith the second applicator frame 421) has a longitudinal stroke, along the first sliding direction Y, at least twice the width of the second support frame 420 and/or of the second applicator frame 421 (and substantially equal to or slightly less than the length of the support surface A and/or of the conveyor 20).

Preferably, the second support frame 420 and/or the second applicator frame 421 is vertically movable along a vertical direction Z (orthogonal to the support surface A) towards and/or away from the support surface A, i.e. alternatively between at least one position distal from the support surface A and at least one position proximal to the support surface

A.

In practice, the second support frame 420 and/or the second applicator frame 421 is supported by the frame 400 with the possibility of sliding vertically along the vertical direction

Z.

Preferably, the second support frame 420 and/or the second applicator frame 421 are allowed two independent vertical translations along the vertical direction Z, of which a main translation and a fine adjustment translation (having a translation stroke smaller than the main translation).

For example, the second support frame 420 is supported by a second support carriage 422.

The second carriage 422 preferably comprises an upper (vertical) support beam 4221 which in turn supports (below) a lower support little frame 4222.

The support little frame 4222 is preferably but not in a limiting manner shaped as a framing.

The support beam 4221 is constrained to the frame 400 by means of a constraint, preferably a prismatic connection, which allows a sliding of the second carriage 422 (as a whole) with respect to the frame 400 with respect to the vertical direction Z.

In practice, the frame 400 comprises a vertical guide (for example one at its crosspiece) engaged by a sliding shoe fixed to the support beam 4221 of the second carriage 422.

Again, the second carriage 422 is constrained to the frame 400 at its opposite facade to that to which the first carriage 412 of the first application device 41 is constrained.

The stroke allowed to the support beam 4221 of the second carriage 422 by the connection with the frame 400 defines the main translation mentioned above.

The second carriage 422 and/or the support beam 4221 is driven to slide along the vertical direction Z, preferably in the two sliding directions, by a linear actuator unit.

Preferably, but not in a limiting manner, the actuator unit comprises (or consists of) a second pneumatic jack 423, which is for example supported by the frame 400, for example at the (centre line of) the crosspiece.

Preferably, the actuator unit can be configured to stop the second carriage 422 in at least a first distal position, in which the second carriage 422 is at the maximum distance from the support surface A (for example in which the translation of the frame 400 along the first sliding direction Y is allowed), and in at least a first proximal position, in which the second carriage 422 is at the minimum distance from the support surface A (for example with the second applicator frame 421 at a given non-zero distance therefrom).

Furthermore, it is possible to provide that the actuator unit can be configured to stop the second carriage 422 in at least an intermediate position between the first distal position and the first proximal position, for example to allow/facilitate the operations of changing the second applicator frame 421 and/or of maintenance/cleaning thereof.

For example, the support little frame 4222 of the second carriage 422 is superimposed in plan on the second support frame 420 (and the two are connected by means of support columns placed, for example, at the vertices of the rectangle).

Furthermore, the second applicator frame 421 is constrained to the second support frame 420 by means of a constraint, preferably a prismatic connection, which allows at least one sliding of the second applicator frame 421 with respect to the second support frame 420 with respect to the vertical direction Z.

The second applicator frame 421 is movable with respect to the second support frame 420, sliding, between a raised position and a lowered position.

The stroke allowed to the second applicator frame 421 by the connection with the second support frame 420 defines the above-mentioned fine adjustment translation.

The second applicator frame 421 is driven to slide, with respect to the second support frame 420, along the vertical direction Z, preferably in the two sliding directions, by a linear actuation unit.

Preferably, but not in a limiting manner, the linear actuation unit can be of the manual or automatic type.

In the illustrated example the linear actuation unit is of a manual type and comprises (or consists of) a plurality of second screw knobs 424 (for example one for each edge), which are for example supported by the second support frame 420 and lie on the second applicator frame 421.

It is not excluded that the linear actuation unit is provided with one or more motors adapted to adjust the height of the second applicator frame 421 with respect to the second support frame 420.

This fine adjustment translation allows to adjust the contact pressure and/or the contact position between the second applicator frame 421 and the (upper surface of the) slab L (as a function of its thickness and/or other processing parameters).

It is also not excluded that the overall translation (i.e. the sum of the aforementioned main translation and the aforementioned fine adjustment translation) of the second applicator frame 421 can be carried out by a single actuator (motorized or manual), for example an electric motor or the like.

Still, the second support frame 420 and/or the second applicator frame 421 is rotatable about a vertical rotation axis R (which is preferably central with respect to the second applicator frame 421, i.e. intersects the same, preferably, at the intersection of the diagonals thereof).

Preferably, the second support frame 420 and/or the second applicator frame 421 is rotatable about a vertical rotation axis R by a rotation angle equal to 180° or 90° (or any desired rotation angle), so as to be able to vary the orientation on the slab L of the second conductive element released by the second applicator frame 421.

Preferably, but not in a limiting manner, the second support frame 420 and/or the second applicator frame 421 are allowed two oscillations/rotations around the vertical rotation axis R, of which one main rotation and one fine adjustment rotation (having a smaller rotation angle than the main rotation).

It is not excluded that the second support frame 420 and/or the second applicator frame 421 is allowed only the main rotation.

For example, the support little frame 4222 is constrained (below) to the support beam 4221 so that it can rotate (exclusively) about the vertical rotation axis R.

In particular, the support little frame 4222 is supported by a preferably motorized slewing ring 4223 having a fixed ring rigidly fixed to the support beam 4221 and a movable ring rigidly fixed (superiorly) to the support little frame 4222.

The rotation allowed to the support little frame 4222 by the connection with the support beam 4221 and by the slewing ring 4223 defines the main rotation mentioned above.

It is not excluded that the main rotation can be carried out manually or with another type of implementation.

Preferably, the second applicator frame 421 can be constrained to the support little frame 4222 of the second support frame 420 by means of a further constraint that allows (small) oscillations of the second applicator frame 421 with respect to the support little frame 4222 about a (further) vertical oscillation axis (for example parallel and eccentric or concentric with respect to the vertical oscillation axis responsible for the main rotation).

In this way it is possible to adjust (in a fine way) the orientation on the horizontal plane of the second applicator frame 421 (i.e. of the second conductive element on the slab L).

In detail, the second applicator frame 421 is hinged (with respect to said further vertical rotation axis) to the support little frame 4222, for example at a short side thereof (i.e. an axial end thereof along the longitudinal axis) and the opposite short side is guided to rotate along circular slots defining a section of circumference arc.

The second applicator frame 421 is driven in oscillation, with respect to the support little frame 4222, around said further axis of vertical oscillation preferably in the two directions, by an adjustment unit.

Preferably, but not in a limiting manner, the adjustment unit can be of the manual (or automatic) type.

In the illustrated example, the adjustment unit is of the manual type and comprises (or consists of) a second knob 425 or two, which is for example inserted into the aforementioned slots and allows the adjustment (when loose) of the orientation and the blocking (when tight) thereof in the desired orientation of the second applicator frame 421.

The rotation/oscillation allowed to the second applicator frame 421 by the connection with the support little frame 4222 defines the fine adjustment rotation mentioned above.

The composition of the main rotation and fine adjustment rotation (where provided) defines the overall rotation of the second applicator frame 421 with respect to the vertical rotation axis R.

Advantageously, the second application apparatus 42, preferably the second support frame 420, and therewith the second applicator frame 421, is movable (translatable) with respect to the conveyor 20 along a second sliding direction X horizontal and orthogonal to the first sliding direction Y.

In this way, it is possible to position the second applicator frame 421 in any given transverse position of the slab L (resting on the support surface A), defined along a horizontal direction and orthogonal to the advancement direction B, and to release a second conductive element thereon and/or to be able to release one (same) second conductive element in two or more different (and non-overlapping) transverse positions of the same slab L.

In detail, the support beam 4221 is slidably associated with the frame 400, preferably at the crosspiece thereof, along said second sliding direction X (i.e. parallel to the longitudinal axis of the crosspiece itself), between two end-of-stroke positions, preferably adjustable, in which for example the second applicator frame 421 is still superimposed on the support surface A and/or is substantially at opposite lateral edges of the support surface A.

Advantageously, the (crosspiece of the) frame 400 comprises longitudinal sliding guides to which suitable sliding shoes fixed to (the support beam 4221 of) the second carriage 422 (which supports the second support frame 420 and/or the second applicator frame 421) are slidably associated allowing the transverse sliding of (the support beam 4221 of) the second carriage 422 (which supports the second support frame 420 and/or the second applicator frame 421) with respect to the frame 400 and, therefore, to the (frame 22 of the) conveyor 20 /support surface A.

Advantageously, (the support beam 4221 of) the second carriage 422 (which supports the second support frame 420 and/or the second applicator frame 421) is movable on the conveyor 20 being able to travel a stroke along the second sliding direction X substantially equal to (or slightly less than) the width of the support surface A (along the direction orthogonal to the advancement direction B), i.e. a stroke substantially equal to the width of the support surface A minus the length of the second applicator frame 421.

(The support beam 4221 of) the second carriage 422 (which supports the second support frame 420 and/or the second applicator frame 421) is driven to slide along the second sliding direction X, preferably in the two sliding directions, by a further linear actuator unit. Preferably, but not in a limiting manner, the further actuator unit comprises (or consists of) a secondary motor 402, preferably provided with an encoder, which is for example supported by the frame 400 (and connects, with appropriate transmissions, for example to belts/chains, to the support beam 4221 of the second carriage 422 that supports the second support frame 420 and/or the second applicator frame 421).

In greater detail, in this way (and thanks to the dimension/length of the second applicator frame 421) it is possible to position the second applicator frame 421 in any two or more given distinct transverse positions of the slab L (resting on the support surface L), defined the second sliding direction X, and to release a respective second conductive element thereon, i.e. to be able to release one (same) second conductive element in two or more given transverse positions of the same slab L.

In practice, the second support frame 420 and/or the second applicator frame 421 can be arranged, thanks to the translation of (the support beam 4221 of) the second carriage 422 along the second sliding direction X, superimposed in plan on any transverse portion of the slab smaller than its total transverse width (for example an entire sub-multiple thereof), or on any two distinct transverse positions of the slab L.

(The support beam 4221 of) the second carriage 422 (and therewith the second applicator frame 421) has a transverse stroke, along the second sliding direction X, at least twice the length of the second support frame 420 and/or of the second applicator frame 421.

Thanks to the composition of the axial translation (of the frame 400 on the support surface A) and of the transverse translation (due to the translation of the second carriage 422 on the frame 400) it is possible to position (as on a Cartesian plane) the second applicator frame 421 at any point (along the first sliding direction Y and the second sliding direction X) of the slab L resting on the support surface A.

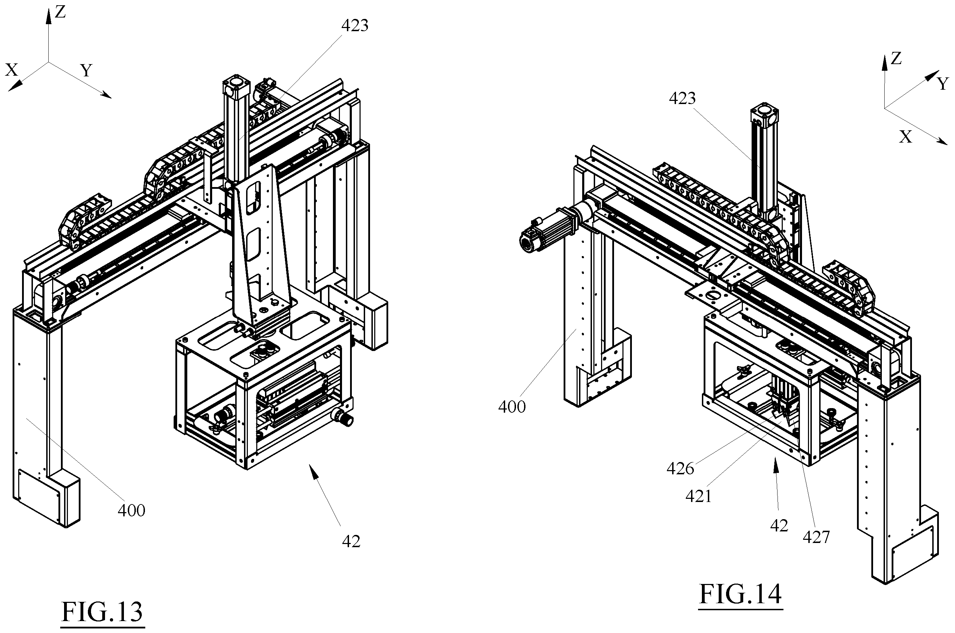

The second applicator frame 421, as illustrated in the figures - in particular shown in Figure 14 -, comprises a (second) (suitably) perforated web (according to a given design/arrangement of holes), adapted to be crossed (in the holes thereof) by the conductive paste (for the creation of the second conductive element, i.e. of the aforementioned inscription and/or design).

The perforated web is supported within the first support frame 410, as mentioned shaped as a (horizontal) framing, for example so that the perforated web lies on a substantially horizontal surface.

The second application apparatus 42 further comprises at least one movable spreading blade on the second applicator frame 421 for spreading the conductive paste thereon and/or for releasing the second conductive element (on the slab) therefrom, for example by passing through the holes of the (second) perforated web by means of the pressure exerted by the doctor blade.

For example, the second application apparatus 42 comprises a second spreading doctor blade 426 which is supported above the second applicator frame 421 for example by the second support frame 420 or by the second carriage 422, in particular by the support little frame 4222 thereof.

The second spreading doctor blade 426 is for example made of metal.

Preferably, the second spreading doctor blade 426 is vertically movable between a raised position, in which it is distal from the second applicator frame 421, and a lowered position, in which it is proximal to the second applicator frame 421, for example at a non-zero distance therefrom or in close proximity thereto.

Preferably, the second spreading doctor blade 426 is driven in vertical translation by an actuator, preferably a pneumatic jack.

In detail, the second spreading doctor blade 426 is fixed to the free (lower) end of the stem of the pneumatic jack.

The second spreading doctor blade 426, moreover, is movable in translation along a second horizontal sliding direction X, for example parallel to the longitudinal axis of the second support frame 420 and/or of the second applicator frame 421 (i.e. orthogonal to the first sliding direction Y when the second applicator frame 421 has longitudinal axis orthogonal to the advancement direction B), for example between two corresponding end positions, preferably adjustable and/or defined by the axial ends of the second applicator frame 421 (and/or of the longitudinal conductive element defined thereby).

Preferably, the body of the pneumatic jack is guided on longitudinal guides (fixed to the second support frame 420 and/or to the second carriage 422, preferably the support little frame 4222) so as to be able to slide along said second horizontal sliding direction X.

A motorized and/or pneumatically operated actuation unit (not illustrated), for example fixed to the second support frame 420 and/or to the second carriage 422, preferably to the support little frame 4222, is configured to drive the translation of the second spreading doctor blade 426 alternately between the two end positions.

For example, the second spreading doctor blade 426 is configured to operate a forward (or spreading) stroke, from an end rest position to an opposite end position, when in the lowered position and a return stroke toward the end rest position when in the raised position.

A conductive paste dispensing unit (not illustrated) is configured to dispense a predetermined amount of conductive paste onto the second applicator frame 421 when the second spreading doctor blade 426 is in the end rest position prior to the forward stroke (so as to be spread along the entire second applicator frame 421 in the forward stroke thereof).

For example, the second application apparatus 42 comprises a second writing doctor blade 427 which is supported above the second applicator frame 421 for example by the second support frame 420 or by the second carriage 422, preferably by the support little frame 4222.

The second writing doctor blade 427 is for example made of rubber and/or a plastic material.

Preferably, the second writing doctor blade 427 is vertically movable between a raised position, in which it is distal from the second applicator frame 421, and a lowered position, in which it is proximal to the second applicator frame 421, for example in forced contact therewith (such as to tension it downwards and bring it into contact with the underlying slab L).

Preferably, the second writing doctor blade 427 is driven in vertical translation by an (independent) actuator, preferably a pneumatic jack.

In detail, the second writing doctor blade 427 is fixed to the free (lower) end of the stem of the pneumatic jack.

The second writing doctor blade 427, moreover, is movable in translation along the second horizontal sliding direction X, for example between two corresponding end positions, preferably adjustable and/or defined by the axial ends of the second applicator frame 421 (and/or of the conductive element defined thereby).

Preferably, the body of the pneumatic jack is guided on (the same mentioned above) longitudinal guides (fixed to the second support frame 420 and/or to the second carriage 422) so as to be able to slide along said horizontal sliding direction.

An actuation unit (preferably the same one that simultaneously drives the second spreading doctor blade 416) that is motorized and/or pneumatically operated (not illustrated), for example fixed to the second support frame 420 and/or to the second carriage 422, preferably to the support little frame 4222, is configured to drive the translation of the second writing doctor blade 427 alternately between the two end positions.

For example, the second writing doctor blade 427 is configured to operate a forward (or writing) stroke, from an end rest position to an opposite end position, when in the lowered position and a return stroke toward the end rest position when in the raised position. The forward stroke of the second writing doctor blade 427 follows the forward stroke (and the subsequent return stroke) of the second spreading doctor blade 426, so as to pass the conductive paste (previously spread by the second spreading doctor blade 426) through (determined and calibrated open pores of) the second applicator frame 421 during the forward stroke of the second writing doctor blade 427 (with the second writing doctor blade itself kept pressed in its lowered position on the second applicator frame itself), thereby releasing a predetermined amount of conductive paste defining the second conductive element (in the predetermined axial position) on the slab L arranged under the second applicator frame 421.

The second application apparatus 42, moreover, could provide an "out of contact" device (not illustrated, as of a type known in the field), which is a servo-actuated device configured to lift the rear front of the second applicator frame 421 in the advancement direction of the second writing doctor blade 427 in its forward stroke, during the forward stroke thereof, so as to detach the portion of the second applicator frame 421 on which the second writing doctor blade 427 has already passed from the slab L (to improve the definition/precision of the conductive element obtained).

The machine 10 could have either the above-described single first application apparatus 41 or the above-described single second application apparatus 42, or as shown in the figures, both application apparatus 41 and 42 as needed.

The machine 10 further comprises an electronic control unit 100 responsible for the automatic/semi-automatic operation of the machine 10.

The electronic control unit 100 is, for example, operatively connected to one or more of the following components of the machine 10:
the photocell, the motor 21 of the conveyor 20, the main motor 401, the secondary motor 402, the first jack 413, the actuators of the first spreading doctor blade 416 and of the first writing doctor blade 417, the second jack 423, the slewing ring 4223 and the actuators of the second spreading doctor blade 426 and of the second writing doctor blade 427.

In the light of what has been described above, the operation of the system 10 is as follows. In practice, thanks to machine 10 it is possible to perform/realize a method of applying a conductive paste on a (surface of a) slab, which provides for:
- arranging a slab, preferably a glass slab (for making a cold leaf or a rear window of a car or other), resting on a horizontal support surface; and
- possibly arranging a conductive paste, for example (but not in a limiting manner) a silver-based conductive paste, for making the first and/or second conductive element.

The method first provides for loading a dosed amount of conductive paste onto the first applicator frame 411 and/or onto the second applicator frame 421.

When the slab L is advanced and brought onto the support surface A, the method provides for detecting (with the photocell) the front face thereof and driving the motor 21 of the conveyor 20 so as to advance the slab L up to a determined axial end-of-stroke position, so that the same is arranged along the advancement direction B in a predetermined desired processing position and all resting on the support surface A.

Subsequently, in general, the method provides for centring and temporarily blocking the slab L on the support surface A, for example by driving the centring unit 30.

In this way, the position on the support surface A of the slab L is determined precisely and uniquely.

At this point, the method provides for driving the application device 40, so as to release, by means of the application device itself, for example the first application apparatus 41 and/or the second application apparatus 42, movable on the support surface A, a conductive element (i.e. a first conductive element and/or a second conductive element) in a first determined axial and/or transverse position on the slab L.

Subsequently, the method provides for translating the application device 40 on the support surface A by operating (with the main motor 401) a translation of the application device 40 along the first sliding direction Y.

Subsequently, the method provides for releasing, by means of the same application device 40 (i.e. said first application apparatus 41 and/or said second application apparatus 42), a further (equal) conductive element (i.e. a said first conductive element and/or a second conductive element) in a second determined axial and/or transverse position on the (same) slab L, wherein the second determined axial and/or transverse position is different from the first axial and/or transverse position.

For example, before releasing the additional conductive element, it could be provided that the application device 40 can be rotated around at least one vertical rotation axis R, so that the additional conductive element (released and/or applied to the slab subsequently) has a different orientation from the conductive element previously released on the same slab.

More in detail, in the case of making a first conductive element (i.e. a longitudinal strip of conductive paste) on the slab L, the method - once the slab L is in position on the support surface A and retained thereon by the centring unit 30 - provides for arranging the first application apparatus 41 by driving the translation thereof (by means of the main motor 401) along the first sliding direction Y, so that the first applicator frame 411 is superimposed in plan to a (first) determined axial position of the slab L in which to make/release/apply a first conductive element.

With the first applicator frame 411 in this position, a first application sequence is started by the first application apparatus 41 which provides for:
- firstly positioning the first applicator frame 411 in its proximal position (by means of the first jack 413);
- and then driving, in sequence, the first spreading doctor blade 416 (in a forward stroke and subsequent return stroke) and the first writing doctor blade 417 (in a forward stroke and subsequent return stroke), thereby applying a first conductive element.

Following this first application sequence, the first applicator frame 411 (repositioned in a raised position or in the intermediate position) is commanded to translate along the first sliding direction Y until the first applicator frame 411 is superimposed in plan on a different (second) determined axial position of the slab L in which to make a further (identical) first conductive element.

With the first applicator frame 411 in this further different position, a second application sequence is started by the first application apparatus 41 which provides for:
- firstly positioning the first applicator frame 411 in its proximal position (by means of the first jack 413);
- and then driving, in sequence, the first spreading doctor blade 416 (in a forward stroke and subsequent return stroke) and the first writing doctor blade 417 (in a forward stroke and subsequent return stroke), thereby applying a second conductive element.

In practice, two identical first conductive elements parallel to and separated from each other are made on the slab L, for example two strips of conductive paste, parallel and arranged in given axial positions of the slab L (orthogonal to the longitudinal axis of the slab itself), which for example after being subjected to a firing process become electrically conductive bars/bands (so-called bus bars), for example for heating the glass, preferably for the anti-fogging/defrosting function thereof.

In the case, however, of making a second conductive element (i.e. an inscription and/or a design/logo or other suitable sign), whether it is to be made on the same slab L where the first conductive elements described above or other slabs are provided, the method - once the slab L is in position on the support surface A and retained thereon by the centring unit 30 - provides for arranging the second application apparatus 42 by driving the translation thereof (by means of the main motor 401) along the first sliding direction Y and/or the translation of the second carriage 422 (by means of the secondary motor 402) along the second sliding direction X, so that the second applicator frame 421 is superimposed in plan on a (first) determined axial and/or transverse position of the slab L in which to make a second conductive element.

With the second applicator frame 421 in this position, a first application sequence is started by the second application apparatus 42 which provides for:
- firstly positioning the second applicator frame 421 in its proximal position (by means of the second jack 423);
- and then sequentially driving the second spreading doctor blade 426 (in a forward stroke and subsequent return stroke) and the second writing doctor blade 427 (in a forward stroke and subsequent return stroke), thereby releasing a first conductive element.

Following this first application sequence, the second applicator frame 421 (repositioned in a raised position or in the intermediate position) is commanded to translate along the first sliding direction Y and/or along the second sliding direction X until the second applicator frame 421 is superimposed in plan on a different (second) determined axial and/or transverse position of the slab L in which to make a further (identical) second conductive element.

Simultaneously or previously/subsequently, the second applicator frame 421 (repositioned in a raised position or in the intermediate position) can be commanded to rotate

(with the slewing ring 4223), for example by 180°, around the vertical rotation axis R, so that the further second conductive element has an opposite orientation with respect to the one previously released on the slab L.

With the second applicator frame 421 in this further different position and possible different orientation, a second application sequence is started by the second application apparatus 42 which provides for:
- firstly positioning the second applicator frame 421 in its proximal position (by means of the second jack 423);
- and then driving, in sequence, the second spreading doctor blade 426 (in a forward stroke and subsequent return stroke) and the second writing doctor blade 427 (in a forward stroke and subsequent return stroke), thereby releasing a further second conductive element (rotated with respect to the other second conductive element previously applied on the slab).

In practice, two identical second conductive elements parallel to and separated from each other and possibly with opposite orientation (i.e. rotated by 180° with respect to each other) are made on the slab L, for example two inscriptions and/or designs, parallel and arranged in given axial and/or transverse positions of the slab L (for example at two opposite points on a diagonal of the slab, so that after installation of the slab on a vertical plane there is always a second conductive element bearing a wording/design that has a correct spatial positioning).

The invention thus conceived is susceptible to many modifications and variants, all falling within the same inventive concept.

Moreover, all details can be replaced by other technically equivalent elements.

In practice, the materials used, as well as the contingent shapes and sizes, can be whatever according to the requirements without for this reason departing from the scope of protection of the following claims.

## Claims

1. Machine for applying conductive paste on slabs comprising:
- a conveyor provided with a horizontal support surface configured to support a slab and to move the slab along a horizontal advancement direction
- a centring unit configured to contact the slab by temporarily blocking and centring it on the support surface; and
- a device for applying a conductive paste movable on the support surface at least along a first sliding direction parallel to the advancement direction, so that a conductive element can be released/applied in two or more given axial positions, defined along the first sliding direction, of the slab on the support surface following a translation along the first sliding direction.

2. The machine according to claim 1, wherein the application device comprises a first applicator frame movable with respect to the conveyor along a first sliding direction parallel to the advancement direction, so as to be able to position the first applicator frame in any given axial position, defined along the advancement direction, of the slab resting on the support surface and to release a conductive element thereon and/or to be able to release a conductive element in two or more axial positions of the same slab.

3. The machine according to claim 2, wherein the first applicator frame has a longitudinal extension along a longitudinal axis substantially horizontal and orthogonal to the first sliding direction and has a length substantially equal to the width of the support surface along a direction orthogonal to the advancement direction and a width less than the length of the slab to be processed so that it can be arranged superimposed in plan in any axial portion thereof that is less than its total axial length, wherein preferably the first applicator frame has a minimum longitudinal stroke along the advancement direction at least twice the width of the first applicator frame.

4. The machine according to any one of claims 2-3, wherein the first applicator frame is configured to release and apply a longitudinal conductive strip on the slab, wherein the conductive strip has a longitudinal extension mainly orthogonal to the advancement direction and extends longitudinally for a main portion of the length of the first applicator frame itself.

5. The machine according to any one of claims 2-4, wherein the first applicator frame is supported by a gantry frame slidably associated with a frame of the conveyor along the first horizontal sliding direction parallel to the advancement direction.

6. The machine according to any one of claims 2-5, wherein the first applicator frame is vertically movable along a vertical direction, alternating between a position distal from the support surface and a position proximal to the support surface.

7. The machine according to any one of claims 2-6, wherein the first applicator frame is associated with at least a writing doctor blade and/or a spreading doctor blade movable vertically and along a second horizontal sliding direction parallel to a longitudinal axis of the first applicator frame.

8. The machine according to claim 1, wherein the application device comprises a second applicator frame, wherein the second applicator frame is movable with respect to the conveyor along a first sliding direction parallel to the advancement direction, so as to be able to position the second applicator frame in any given axial position, defined along the advancement direction, of the slab resting on the support surface and to release a conductive element thereon and/or to be able to release a conductive element in two or more axial positions of the same slab.

9. The machine according to the preceding claim, wherein the second applicator frame is movable with respect to the conveyor along a second horizontal sliding direction and orthogonal to the first sliding direction, so as to be able to position the second applicator frame in any given transverse position, defined along a horizontal direction and orthogonal to the advancement direction, of the slab resting on the support surface and to release a conductive element thereon and/or to be able to release a conductive element in two or more transverse positions of the same slab.

10. The machine according to any one of claims 8-9, wherein the second applicator frame is supported by a carriage slidably associated, along the second sliding direction, with a gantry frame slidably associated with a frame of the conveyor along the first horizontal sliding direction parallel to the advancement direction.

11. The machine according to any one of claims 8-10, wherein the second applicator frame is vertically movable along a vertical direction, alternating between a position distal from the support surface and a position proximal to the support surface.

12. The machine according to any one of claims 8-11, wherein the second applicator frame is rotatable about a vertical rotation axis, preferably by an angle of rotation of 180°, so as to be able to vary the orientation on the slab of the conductive element released from the second applicator frame.

13. The machine according to any one of claims 8-12, wherein the second applicator frame has a longitudinal extension along a substantially horizontal longitudinal axis and has a length less than the width of the support surface along a direction orthogonal to the advancement direction, wherein preferably the second applicator frame has a minimum cross-sectional stroke along the second sliding direction at least equal to two times the length of the second applicator frame, and has a width less than the length of the slab to be processed, wherein preferably the second applicator frame has a minimum longitudinal stroke along the advancement direction of at least twice the width of the second applicator frame, so that it can be arranged superimposed in plan on any axial and transverse portion thereof included in its total length and width.

14. The machine according to any one of claims 8-13, wherein the second applicator frame is configured to release and apply an inscription and/or design on the slab.

15. The machine according to any one of claims 8-14, wherein the second applicator frame is associated with at least one writing doctor blade and/or one spreading doctor blade movable vertically and along a horizontal sliding direction parallel to a longitudinal axis of the second applicator frame.

16. A method of applying a conductive paste to slabs, preferably for making conductive elements on the slab, by means of a machine according to any one of the preceding claims, comprising:
- arranging a slab resting on a horizontal support surface;
- centring and temporarily blocking the slab on the support surface;
- releasing and/or applying a conductive element to the slab, by means of an application device movable on the support surface, in a first given axial position of the slab;
- translating the application device on the support surface and on the slab centred there; and
- releasing and/or applying an additional conductive element in a second, given axial position on the slab that is different from the first axial position by means of said application device.

17. The method according to the preceding claim, wherein the application device is rotated about at least one vertical rotation axis before releasing/applying the further conductive element, so that the further conductive element has a different orientation from the conductive element previously released/applied on the slab.

18. The method according to any one of claims 16-17, which comprises arranging a conductive paste for making each conductive element, wherein preferably the conductive paste is silver-based.
